(19) Europäisches Patentamt
European Patent Office
Office européen des brevets

(11) EP 4 036 187 A1

(12) **EUROPEAN PATENT APPLICATION**
published in accordance with Art. 153(4) EPC

(43) Date of publication:
**03.08.2022 Bulletin 2022/31**

(21) Application number: **20870226.6**

(22) Date of filing: **23.09.2020**

(51) International Patent Classification (IPC):
***C09K 3/18** (2006.01)* ***B32B 15/08** (2006.01)*
***C23C 26/00** (2006.01)*

(52) Cooperative Patent Classification (CPC):
**B32B 15/08; C09K 3/18; C23C 26/00**

(86) International application number:
**PCT/JP2020/035853**

(87) International publication number:
**WO 2021/060296 (01.04.2021 Gazette 2021/13)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **27.09.2019 JP 2019177847**

(71) Applicant: **NITTO DENKO CORPORATION**
**Ibaraki-shi**
**Osaka 567-8680 (JP)**

(72) Inventors:
- **MARUOKA Nobuaki**
  **Ibaraki-shi, Osaka 567-8680 (JP)**
- **FUJITA Hiroyuki**
  **Ibaraki-shi, Osaka 567-8680 (JP)**
- **KOSAKA Aika**
  **Ibaraki-shi, Osaka 567-8680 (JP)**

(74) Representative: **Gill Jennings & Every LLP**
**The Broadgate Tower**
**20 Primrose Street**
**London EC2A 2ES (GB)**

(54) **FILM, AND METHOD FOR PRODUCING SAME**

(57) The present invention relates to a film (100) including a base layer (12) and an oil-containing layer (14) formed on the base layer (12), wherein the oil-containing layer (14) contains an oil ingredient which bleeds out from a surface of the oil-containing layer (14) at a given temperature or lower, the base layer (12) is an elemental metal or a multilayer structure including a metal layer, and the elemental metal or the metal layer is in contact with the oil-containing layer (14).

*FIG. 1*

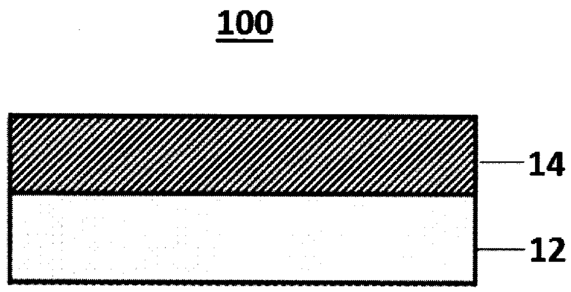


EP 4 036 187 A1

## Description

TECHNICAL FIELD

The present invention relates to a film and a method for producing the film.

BACKGROUND ART

The adhesion of ice (icing) to object surfaces or the adhesion of snowflakes (snow accretion) to object surfaces due to snowfall causes damage and obstacles in various fields. For example, icing of an airplane, snow accretion to or freezing on lower portions of a locomotive, snow accretion to the head lamps of a motor vehicle, icing of the blades of a wind-power generator, snow accretion to or freezing on the lights of a traffic signal, etc. can be obstacles to the service, operation, and safety of these. Meanwhile, snow accretion to or freezing on the roof of a dwelling house, a signboard, etc. can be causative of damage to these structures or of human injuries or the like due to the falling of snow masses.

In order to avoid such damage and obstacles, an attempt has, for example, been made to apply a fluororesin having low surface energy to object surfaces. This technique, however, has a problem in that a long-lasting effect is not obtained.

Patent Document 1 discloses a coating composition for preventing ice/snow accretion obtained by mixing a chemical reaction type silicone rubber as a base, a water-repellent compound such as a silicone oil, and a water-soluble organic compound. The technique of Patent Document 1 specifically has a feature wherein a layer including a silicone-rubber matrix and a silicone oil contained therein is formed and the oil is caused to bleed out from the layer (the oil is caused to ooze out to the surface), thereby causing the ice or snow to slide off.

CITATION LIST

PATENT LITERATURE

Patent Document 1: JP-A-62-252477

SUMMARY OF INVENTION

TECHNICAL PROBLEMS

However, the technique of Patent Document 1 has had a problem in that the oil which has bled out is reabsorbed by the base, resulting in a decrease in the function of preventing snow/ice accretion.

In addition, in this field, conventional films having the function of preventing snow/ice accretion are required to have improved adhesion between a base layer and an oil-containing layer containing a water-repellent compound such as a silicone oil.

Meanwhile, underwater structures such as ships undergo the adhesion and growth of marine organisms, such as barnacles, oysters, blue mussels, hydras, serpulas, sea squirts, sea mosses, sea lettuces, green laver, and periphytic diatoms, on the portions thereof which are in contact with seawater. This results in undesirable situations such as decreases in equipment/machine performance, e.g., an increase in fluid resistance and a decrease in thermal conductivity, and the diffusion of adherent marine organisms to foreign sea areas. Moreover, removal of the adherent marine organisms requires much labor and time to cause losses in profitability.

An object of the present invention, therefore, is to provide a film in which an oil that has bled out is prevented from being reabsorbed by the base and which has excellent adhesion between a base layer and an oil-containing layer and is effective in preventing snow or ice accretion or the adhesion of aquatic organisms to a surface of an object of interest, and a method for producing the film.

SOLUTION TO THE PROBLEMS

The present inventors diligently made investigations and, as a result, have discovered that those problems can be overcome by disposing an elemental metal or a metal layer as a portion in contact with an oil-containing layer. The present invention has been thus completed.

The present invention is as shown below under [1] to [8].

[1] A film including a base layer and an oil-containing layer formed on the base layer, wherein

the oil-containing layer contains an oil ingredient which bleeds out from a surface of the oil-containing layer at a given temperature or lower,
the base layer is an elemental metal or a multilayer structure including a metal layer, and
the elemental metal or the metal layer is in contact with the oil-containing layer.

[2] The film according to [1] wherein the base layer is aluminum.
[3] The film according to [1] wherein the base layer is a multilayer structure including a resin layer and a metal layer formed thereon, the metal layer being a vapor-deposited metal layer.
[4] The film according to [3] wherein the vapor-deposited metal layer includes aluminum.
[5] The film according to any one of [1] to [4] which includes a pressure-sensitive adhesive layer, the base layer, and the oil-containing layer in this order.
[6] The film according to [5] wherein the base layer includes an elemental metal or a multilayer structure including a metal layer, on the side where the pressure-sensitive adhesive layer is provided, and the elemental metal or the metal layer is in contact with the pressure-sensitive adhesive layer.
[7] The film according to any one of [1] to [6] which is for use in preventing a surface of an object from suffering snow or ice accretion thereto or the adhesion of aquatic organisms thereto.
[8] A method for producing the film according to any one of [1] to [7], which includes a step in which a resin composition including a polymer ingredient and an oil ingredient is applied to a surface of the base layer and the obtained coating film is cured to form an oil-containing layer, wherein

the oil ingredient contained in the oil-containing layer bleeds out from a surface of the oil-containing layer at a given temperature or lower,
the base layer is an elemental metal or a multilayer structure including a metal layer, and
the oil-containing layer is formed on the base layer so that the elemental metal or the metal layer is in contact with the oil-containing layer.

ADVANTAGEOUS EFFECTS OF THE INVENTION

In the film of the present invention, the oil which has bled out can be prevented from being reabsorbed by the base, since either an elemental metal or a multilayer structure including a metal layer is used as a base layer and since the oil-containing layer has been formed so that the elemental metal or the metal layer is in contact with the oil-containing layer.
Furthermore, since an elemental metal or a multilayer structure including a meal layer is used as the base layer, the adhesion between the base layer and the oil-containing layer can be improved.
Moreover, since an elemental metal or a multilayer structure including a meal layer is used as the base layer, improvements in mechanical strength, heat resistance, and cold resistance are also attained. In addition, since the adhesion between the base layer and the oil-containing layer can be maintained over a long period, this film is effective in preventing snow or ice accretion or the adhesion of aquatic organisms to a surface of an object of interest.

BRIEF DESCRIPTION OF DRAWINGS

[Fig. 1] Fig. 1 is a cross-sectional view for explaining one embodiment of the film of the present invention.
[Fig. 2] Fig. 2 is a cross-sectional view for explaining another embodiment of the film of the present invention.
[Fig. 3] Fig. 3 is a cross-sectional view for explaining still another embodiment of the film of the present invention.
[Fig. 4] Fig. 4 is a cross-sectional view for explaining a further embodiment of the film of the present invention.

DESCRIPTION OF EMBODIMENTS

Embodiments of the present invention are explained in more detail below, but the invention is not limited to the following embodiments in any way.
In the present invention, the term "film" means both a film and a sheet which are defined in JIS K 6900:1994. According to the definition given in JIS K 6900:1994, a film is a thin and flat product which has an extremely small thickness for its length and width and has any specified maximum thickness. Films are usually supplied in a roll form. Meanwhile, a sheet is a flat product which is thin and generally has a small thickness for its length and width. There is no clear boundary between films and sheets, and the term "film" used in this description has a conception including sheets.
Fig. 1 is a cross-sectional view for explaining one embodiment of the film of the present invention.

The film 100 shown as an embodiment in Fig. 1 includes a base layer 12 and an oil-containing layer 14 formed on the base layer 12.

The oil-containing layer 14 contains an oil ingredient, which bleeds out from a surface of the oil-containing layer 14 at a given temperature or lower.

In the embodiment shown in Fig. 1, the base layer 12 is an elemental metal, and this elemental metal is in contact with the oil-containing layer 14.

Examples of the elemental metal include aluminum, copper, silver, iron, nickel, tin, and stainless steel. Preferred of these is aluminum, e.g., soft aluminum and hard aluminum. Soft aluminum is especially preferred. Soft aluminum is commercially available, and examples thereof include trade name Soft Aluminum (trade name 1N30), manufactured by Toyo Aluminum K.K.

Fig. 2 is a cross-sectional view for explaining another embodiment of the film of the present invention.

The film 102 shown as an embodiment in Fig. 2 includes a base layer 12 which is a multilayer structure including a metal layer 124. Specifically, the multilayer structure can be one composed of a resin layer 122 and the metal layer 124 disposed thereon. The metal layer 124 is in contact with an oil-containing layer 14.

Examples of the metal in the metal layer 124 include the same metals as those shown above as examples of the elemental metal, and a preferred range thereof is also the same.

In the base layer, the elemental metal or the metal layer has a surface free energy (γs) of preferably 50 $mJ/m^2$ or higher, more preferably 55 $mJ/m^2$ or higher. In cases when the surface free energy (γs) of the elemental metal or metal layer in the base layer is within that range, the adhesion between the base layer and the oil-containing layer can be improved.

In determining the surface free energy (γs) of the elemental metal or metal layer in the base layer, pure water, diiodomethane, and ethylene glycol each having a known surface tension are used as testing liquids to measure a contact angle between the elemental metal or the metal layer and each of the testing liquids with a contact angle meter. From the obtained contact angles, the free surface energy (γs) is determined by the Kitazaki-Hata method (see KITAZAKI yasuaki et al., Journal of the Adhesion Society of Japan, Vol. 8, No. 3, 1972, pp. 131-141).

The contact angles with the elemental metal or metal layer in the base layer are determined, for example, by using each testing liquid in an amount of 2 μL to examine each of five points for contact angle with contact angle meter Type DM-701 (manufactured by Kyowa Interface Science Co., Ltd.), excluding maximum and minimum values from the five measured values, and calculating an average of the remaining three measured values.

The resin constituting the resin layer 122 is not particularly limited. Examples thereof include polyurethane resins, polyurethane/acrylic resins, rubber-based resins, vinyl chloride resins, polyester resins, silicone resins, elastomers, fluororesins, polyamide resins, polyolefin resins (polyethylene, polypropylene, etc.), ionomers, and poly(ethylene terephthalate) resins. From the standpoint of applicability to objects of interest, it is preferred to use any of polyester resins, ionomers, and poly(ethylene terephthalate) resins among those. Only one resin may be used for constituting the resin layer, or two or more resins may be used therefor.

The metal layer 124 is preferably formed, for example, as a vapor-deposited metal layer by a known vapor deposition method, from the standpoint of improving the effects of the present invention.

A thickness of the base layer 12 may be suitably set in accordance with applications. In the case where the base layer 12 is constituted of an elemental metal, the thickness thereof is preferably 20-200 μm, more preferably 50-150 μm, from the standpoint of improving the effects of the present invention.

In the case where the base layer 12 is constituted of the multilayer structure, the thickness of the resin layer 122 is preferably 50-1,000 μm, more preferably 100-800 μm, from the standpoint of improving the effects of the present invention. In the case where the metal layer 124 is a vapor-deposited metal layer, the thickness thereof is preferably 5-300 nm, more preferably 10-200 nm, from the standpoint of improving the effects of the present invention.

Next, the oil-containing layer 14 is explained.

The oil ingredient contained in the oil-containing layer 14 bleeds out from the surface of the oil-containing layer 14 at a given temperature or lower to cover the film surface. Because of such configuration of the film according to this embodiment, a snow mass or ice which is adherent to the surface of the film has portions that are not in direct contact with the film. The snow mass or ice hence has reduced frictional force to become apt to fall due to its own weight, and the film surface has further improved slip properties due to the oil ingredient that has bled out. Consequently, the snow mass or ice can be caused to fall by itself in a shorter time period. Furthermore, the improved slip properties can inhibit the adhesion of aquatic organisms to an object of interest (hereinafter, the effect of preventing ice/snow accretion and the effect of preventing aquatic-organism adhesion are sometimes called the desired effects of the present invention).

The oil-containing layer 14 can be, for example, a layer configured of a polymer ingredient as a matrix and the oil ingredient contained therein.

(Polymer Ingredient)

The polymer ingredient is not particularly limited. Examples thereof include silicone resins, polyurethane resins, polyurethane-acrylic resins, vinyl chloride resins, polyester resins, elastomers, fluororesins, polyamide resins, polyolefin resins (polyethylene, polypropylene, etc.), and acrylic resins. Preferred of these are silicone resins, from the standpoint that silicone resins are excellent in terms of the effect of causing oil-ingredient bleeding and outdoor exposure durability.
Any desired appropriate silicone resin can be employed unless the effects of the present invention are lessened thereby. Only one silicone resin may be used or two or more silicone resins may be used. Such silicone resins may be condensation type silicone resins or may be addition type silicone resins. Furthermore, such a silicone resin may be a one-pack type silicone resin (e.g., a one-pack type room-temperature-vulcanizing (RTV) resin), which is dried alone, or a two-pack type silicone resin (e.g., a two-pack type room-temperature-vulcanizing (RTV) resin).
Examples of the silicone resins include one-pack type RTV rubbers manufactured by Shin-Etsu Chemical Co., Ltd. (e.g., KE-3423, KE-347, KE-3475, KE-3495, KE-4895, KE-4896, KE-1830, KE-1884, KE-3479, KE-348, KE-4897, KE-4898, KE-1820, KE-1825, KE-1831, KE-1833, KE-1885, KE-1056, KE-1151, KE-1842, KE-1886, KE-3424G, KE-3494, KE-3490, KE-40RTV, KE-4890, KE-3497, KE-3498, KE-3493, KE-3466, KE-3467, KE-1862, KE-1867, KE-3491, KE-3492, KE-3417, KE-3418, KE-3427, KE-3428, KE-41, KE-42, KE-44, KE-45, KE-441, KE-445, KE-45S, etc.), two-pack type RTV rubbers manufactured by Shin-Etsu Chemical Co., Ltd. (e.g., KE-1800T-A/B, KE-66, KE-1031-A/B, KE-200, KE-118, KE-103, KE-108, KE-119, KE-109E-A/B, KE-1051J-A/B, KE-1012-A/B, KE-106, KE-1282-A/B, KE-1283-A/B, KE-1800-A/B/C, KE-1801-A/B/C, KE-1802-A/B/C, KE-1281-A/B, KE-1204-A/B, KE-1204-AL/BL, KE-1280-A/B, KE-513-A/B, KE-521-A/B, KE-1285-A/B, KE-1861-A/B, KE-12, KE-14, KE-17, KE-113, KE-24, KE-26, KE-1414, KE-1415, KE-1416, KE-1417, KE-1300T, KE-1310ST, KE-1314-2, KE-1316, KE-1600, KE-1603-A/B, KE-1606, KE-1222-A/B, KE-1241, etc.), silicone sealants manufactured by Shin-Etsu Chemical Co., Ltd. (e.g., KE-42AS, KE-420, KE-450, etc.), rubber compounds manufactured by Shin-Etsu Chemical Co., Ltd. (e.g., KE-655-U, KE-675-U, KE-931-U, KE-941-U, KE-951-U, KE-961-U, KE-971-U, KE-981-U, KE-961T-U, KE-971T-U, KE-871C-U, KE-9410-U, KE-9510-U, KE-9610-U, KE-9710-U, KE-742-U, KE-752-U, KE-762-U, KE-772-U, KE-782-U, KE-850-U, KE-870-U, KE-880-U, KE-890-U, KE-9590-U, KE-5590-U, KE-552-U, KE-582-U, KE-552B-U, KE-555-U, KE-575-U, KE-541-U, KE-551-U, KE-561-U, KE-571-U, KE-581-U, KE-520-U, KE-530B-2-U, KE-540B-2-U, KE-1551-U, KE-1571-U, KE-152-U, KE-174-U, KE-3601SB-U, KE-3711-U, KE-3801M-U, KE-5612G-U, KE-5620BL-U, KE-5620W-U, KE-5634-U, KE-7511-U, KE-7611-U, KE-765-U, KE-785-U, KE-7008-U, KE-7005-U, KE-503-U, KE-5042-U, KE-505-U, KE-6801-U, KE-136Y-U, etc.), LIMSs (liquid-silicone-rubber injection molding systems) manufactured by Shin-Etsu Chemical Co., Ltd. (e.g., KEG-2000-40A/B, KEG-2000-50A/B, KEG-2000-60A/B, KEG-2000-70A/B, KEG-2001-40A/B, KEG-2001-50A/B, KE-1950-10A/B, KE-1950-20A/B, KE-1950-30A/B, KE-1950-35A/B, KE-1950-40A/B, KE-1950-50A/B, KE-1950-60A/B, KE-1950-70A/B, KE-1935A/B, KE-1987A/B, KE-1988A/B, KE-2019-40A/B, KE-2019-50A/B, KE-2019-60A/B, KE-2017-30A/B, KE-2017-40A/B, KE-2017-50A/B, KE-2090-40A/B, KE-2090-50A/B, KE-2090-60A/B, KE-2090-70A/B, KE-2096-40A/B, KE-2096-50A/B, KE-2096-60A/B, etc.), LR7665 Series, manufactured by Wacker Asahikasei Silicone Co., Ltd., LR3033 Series, manufactured by Wacker Asahikasei Silicone Co., Ltd., TSE3032 Series, manufactured by Momentive Performance Materials Inc., and Sylgard (registered trademark) 184, manufactured by Dow Corning Toray Co., Ltd.
Of these, two-pack type silicone resins are preferred from the standpoint of the property of undergoing phase separation from the oil ingredient which bleeds out on the surface at a given temperature. Specifically, more preferred are KE-1950-10A/B, KE-1950-20A/B, KE-1950-30A/B, KE-1950-35A/B, KE-1950-40A/B, KE-1950-50A/B, KE-1950-60A/B, KE-1950-70A/B, KE-1935A/B, and the like.

(Oil Ingredient)

The oil ingredient is not particularly limited so long as it bleeds out to the film surface. Examples thereof include silicone oils, fluorochemical oils, hydrocarbon oils, polyether oils, ester oils, phosphorus compound oils, and mineral oils. Silicone oils are preferred of these from the standpoints of the effect of preventing snow/ice accretion and bleeding effect. The oil ingredient may be a single oil or may be a combination of two or more oils.
Examples of the silicone oils include silicone oils represented by general formula (1).

[Chem. 1]

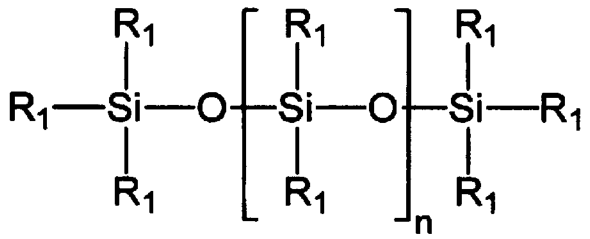

(1)

In general formula (1), the Ri moieties each independently represent an alkyl group having 1-10 carbon atoms, an aryl group, an aralkyl group, a fluoroalkyl group, a polyether group, a carbinol group, an amino group, an epoxy group, a silanol group, or a hydroxyl group, and n represents an integer of 0-150. The n moieties may be the same or different.

Ri in general formula (1) is preferably an alkyl group having 1-10 carbon atoms, a phenyl group, a polyether group, a carbinol group, an amino group, or an epoxy group.

Specific examples of the silicone oils represented by general formula (1) include a dimethyl silicone oil, in which all the Ri moieties are methyl groups, a phenyl methyl silicone oil in which some of the methyl groups of the dimethyl silicone oil have been replaced by phenyl groups, a polyether-group-containing silicone oil in which some of the methyl groups have been replaced by polyether groups, a carbinol-group-containing silicone oil in which some of the methyl groups have been replaced by carbinol groups, an amino-group-containing silicone oil in which some of the methyl groups have been replaced by amino groups, and an epoxy-group-containing silicone oil in which some of the methyl groups have been replaced by epoxy groups. Preferred of these are the phenyl methyl silicone oil, the polyether-group-containing silicone oil, and the carbinol-group-containing silicone oil, because these silicone oils have neither reactivity with silicone resins, in the case where a silicone resin is used as the polymer ingredient, nor self-condensation properties.

The silicone oils represented by general formula (1) each have a number-average molecular weight of preferably 100-40,000, more preferably 200-20,000.

The silicone oils each have a viscosity at 25°C of preferably 1-10,000 cSt, more preferably 5-5,000 cSt, still more preferably 8-1,000 cSt, especially preferably 10-500 cSt. Silicone oils having a viscosity at 25°C within that range bring about excellent snow/ice slip properties, making it possible to obtain an excellent snow/ice accretion preventive effect.

Specific examples of such silicone oils include silicone oils manufactured by Momentive Performance Materials Japan LLC (e.g., TSF431, TSF433, TSF437, and TSF451 Series), silicone oils manufactured by Shin-Etsu Chemical Co., Ltd. (e.g., KF96L Series, KF96 Series, KF69 Series, KF99 Series, KF50 Series, KF54 Series, KF410 Series, KF412 Series, KF414 Series, FL Series, KF-6000, KF-6001, KF-6002, KF-6003, X-22-4039, PAM-E, KF-8010, KF-8012, KF-8008, KF-4917, X-22-163, etc.), silicone oils manufactured by Dow Corning Toray Co., Ltd. (e.g., BY16-846 Series, SF8416 Series, SH200 Series, SH203 Series, SH230 Series, SF8419 Series, FS1265 Series, SH510 Series, SH550 Series, SH710 Series, FZ-2110 Series, FZ-2203 Series, BY16-201, etc.), and silicone oils manufactured by Wacker Asahikasei Silicone Co., Ltd. (e.g., AK Series, AKF Series, L Series, W Series, AP Series, AR Series, and AS Series).

From the standpoint of the property of undergoing phase separation from the polymer ingredient, it is preferred to use TSF437, KF-50 Series, KF54 Series, KF-6000, KF-6001, KF-6002, or the like among those. It is more preferred to use KF96 Series, TSF451 Series, or the like in combination with any of these oil ingredients in order to enhance the affinity thereof for the polymer ingredient.

Meanwhile, examples of the fluorochemical oils include perfluoropolyethers, perfluorodecalin, and perfluorooctane. Perfluoropolyethers are preferred from the standpoint of chemical stability.

Examples of the perfluoropolyethers include compounds represented by the structural formula $A\text{-}(C_3F_6O)_x(CF_2O)_y(C_2F_4O)_z\text{-}B$ (wherein terminal group A is any of $-F$, $-CF_3$, $-C_2F_5$, $-C_3F_7$, $-CF(CF_3)OCF_3$, $-OF$, $-OCF_3$, $-OC_2F_5$, $-OC_3F_7$, and $-OCF(CF_3)OCF_3$, terminal group B is any of $-CF_3$, $-C_2F_5$, $-C_3F_7$, and $-CF(CF_3)OCF_3$, and x, y, and z are each 0 or a positive integer and satisfy x+y+z>1; viscosity at 25°C, 50-500,000 cSt).

Specific examples of such perfluoropolyethers include

$CF_3O\text{-}(CF_2CF(CF_3)O)_x(CF_2O)_y\text{-}CF_3$ (wherein x and y are as defined above),
$CF_3O\text{-}(CF_2O)_y(C_2F_4O)_z\text{-}CF_3$ (wherein y and z are as defined above),
$CF_3O\text{-}(CF_2CF(CF_3)O)X\text{-}CF_3$ (wherein x is as defined above), and $F\text{-}(CF_2CF_2CF_2O)_x\text{-}C_2F_5$ (where x is as defined above).

(Other Ingredients)

The oil-containing layer 14 may contain other ingredients in accordance with applications, so long as the inclusion thereof does not lessen the effects of the present invention. Examples of the other ingredients include solvents, liquid paraffins, surfactants, antibacterials, ultraviolet absorbers, fillers, and crosslinking agents. One of these may be used alone, or two or more thereof may be used in combination.

Examples of the solvents include ethyl acetate and liquid hydrocarbons such as hexane, heptane, benzene, toluene, xylene, and 1-tetradecene.

Examples of the liquid paraffins include P-40, P-55, P-60, P-70, P-80, P-100, P-120, P-150, P-200, P-260, and P-350, manufactured by MORESCO Corp., and hydrocarbon-based liquid paraffins manufactured by Wako Pure Chemical Industries, Ltd.

Examples of the surfactants include anionic surfactants, nonionic surfactants, amphoteric surfactants, and cationic surfactants.

Examples of the anionic surfactants include alkylbenzenesulfonates, alkyl or alkenyl ether sulfates, alkyl or alkenyl sulfates, α-olefinsulfonates, α-sulfofatty acids or ester salts, alkanesulfonates, saturated or unsaturated fatty acid salts, (alkyl or alkenyl ether)carboxylates, amino acid type surfactants, N-acylamino acid type surfactants, and alkyl or alkenyl phosphates or salts thereof.

Examples of the nonionic surfactants include polyoxyalkylene alkyl or alkenyl ethers, polyoxyethylene alkylphenyl ethers, higher fatty acid alkanol amides or alkylene oxide adducts thereof, sucrose fatty acid esters, alkylglycosides, fatty acid glycerin monoesters, and alkylamine oxides.

Examples of the amphoteric surfactants include carboxyl type or sulfobetaine type amphoteric surfactants.

Examples of the cationic surfactants include quaternary ammonium salts.

Examples of the antibacterials include Azoxystrobin, Benalaxyl, Benomyl, Bitertanol, Bromuconazole, Captafol, Captan, Carbendazim, Chinomethionate, Chlorothalonil, Chlozolinate, Cyprodinil, Dichlofluanid, Diclofen, Diclomezine, Dicloran, Diethofencarb, Dimethomorph, Diniconazol, Dithianon, Epoxiconazole, Famoxadone, Fenarimol, Fenbuconazole, Fenfuram, Fenpiclonil, Fentin, Fluazinam, Fludioxonil, Fluoroimide, Fluquinconazole, Flusulfamide, Flutolanil, Folpet, hexachlorobenzene, Hexaconazole, Imibenconazole, Ipconazole, Iprodione, Kresoxim-methyl, Manzeb, Maneb, Mepanipyrim, Mepronil, Metconazole, Metiram, nickel bis(dimethyl dithiocarbamate), Nuarimol, Oxine-copper, oxolinic acid, Pencycuron, Phthalide, Procymidone, Propineb, quintozene, sulfur, Tebuconazole, Tecloftalam, Tecnazene, thifluzamide, Thiophenate-methyl, Thiram, Tolclofos-methyl, Tolylfluanid, Triadimefon, Triadimenol, Triazoxide, Triforine, Triticonazole, Vinclozolin, Zineb, and Ziram.

Examples of natural antibacterials include moso bamboo extract, hinokitiol, garlic extract, and herbal-medicine ingredients such as licorice. Examples of the antibacterials further include inorganic antibacterials such as silver, copper, zinc, tin, lead, and gold.

According to need, any of the following can be used as a support for these inorganic antibacterials: zeolite, hydroxyapatite, calcium carbonate, silica gel, calcium aluminum silicate, polysiloxane compounds, zirconium phosphate, zirconium sulfate, ion exchangers, zinc oxide, and the like.

Examples of synthetic antibacterials include 2-pyridinethiol-1-oxide, p-chloro-m-cresol, polyhexamethylenehiguanide, hydrochloride, benzethonium chloride, alkylpolyaminoethyl glycines, benzisothiazoline, 5-chloro-2-methyl-4-isothiazolin-3-one, 1,2-benzisothiazolin-3-one, and 2,2'-dithiobis(pyridine-1-oxide).

Examples of the ultraviolet absorbers include TINUVIN 571, TINUVIN 460, TINUVIN 213, TINUVIN 234, TINUVIN 329, and TINUVIN 326, manufactured by BASF A.G.

Examples of the fillers include silica particles and diatomaceous earth. From the standpoint of dispersibility, a preferred filler is particles, the surface of which has undergone a hydrophobizing treatment. Examples of methods for such a surface treatment include a method in which a surface treatment is conducted with dimethylpolysiloxane, dimethyldichlorosilane, hexamethylenedisilazane, cyclic dimethylsiloxane, or the like. Such particles having a hydrophobized surface have a size of preferably 5-300 nm in terms of average particle diameter.

Examples of the crosslinking agents include isocyanate compounds, epoxy compounds, melamine compounds, metal chelate compounds, oxazoline compounds, aziridine compounds, and ethyleneimine.

The oil ingredient is caused to be contained in a resin constituted of the polymer ingredient. The proportion of the oil ingredient to be contained to 100 parts by mass of the polymer ingredient is, for example, 25-400 parts by mass, preferably 50-300 parts by mass, more preferably 75-250 parts by mass, especially preferably 100-200 parts by mass.

By regulating the amount of the contained oil ingredient to 25 parts by mass or larger per 100 parts by mass of the polymer ingredient, the oil ingredient is made to sufficiently bleed out and the desired effects of the present invention can be exhibited. Meanwhile, by regulating the amount of the contained oil ingredient to 400 parts by mass or less, the oil-containing layer is inhibited from decreasing in strength.

In this embodiment, a lower limit of the proportion of the contained polymer ingredient to the whole oil-containing layer 14 is preferably 10 mass% or higher, more preferably 15 mass% or higher, still more preferably 25 mass% or

higher. Meanwhile, an upper limit thereof is preferably 90 mass% or less, more preferably 80 mass% or less, still more preferably 70 mass% or less. In cases when the content of the polymer ingredient is within that range, the oil ingredient is made to sufficiently bleed out and the desired effects of the present invention can be exhibited.

Examples of methods for causing the oil ingredient to be contained in a resin constituted of the polymer ingredient include a method in which a resin composition obtained by mixing the polymer ingredient with the oil ingredient and optionally with other ingredients is heated and cured. By heating the resin composition, the polymer ingredient is caused to form a matrix and the oil ingredient is dispersed therein.

The thickness of the oil-containing layer 14 may be suitably decided in accordance with applications, but is preferably 0.05-3 mm (50-3,000 μm). In cases when the thickness of the oil-containing layer 14 is 0.05 mm or larger, not only the oil-containing layer 14 has improved outdoor exposure durability but also the oil ingredient can be contained in an increased amount to heighten the bleeding effect. The desired effects of the present invention can hence be improved. Meanwhile, in cases when the thickness of the oil-containing layer is 3 mm or less, the film has satisfactory handleability.

The lower limit of the thickness of the oil-containing layer 14 is more preferably 0.075 mm or larger, still more preferably 0.1 mm or larger. Meanwhile, the upper limit of the thickness of the oil-containing layer 14 is more preferably 2.5 mm or less, still more preferably 2 mm or less.

The oil-containing layer 14 can be configured so as to have an appropriate bleeding temperature according to a use environment so that the oil ingredient bleeds out at a given temperature or lower. For example, in cases when the given temperature has been set at 0°C, an oil ingredient which bleeds out at 0°C or lower is suitably selected and used to produce a film from which the oil ingredient can be caused to bleed out when the temperature of the surrounding air has declined to 0°C or lower.

In the film according to this embodiment, the base layer 12 is less permeable to the oil ingredient and the oil ingredient which has bled out can be inhibited from being reabsorbed by the base layer 12, since, in particular, the base layer 12 is either an elemental metal or a multilayer structure including a metal layer 124 and the elemental metal or the metal layer 124 is in contact with the oil-containing layer.

Even without an adhesion-promoting treatment, such as a primer treatment or a corona treatment, of the base layer 12, tenacious adhesion is attained between the base layer 12 and the oil-containing layer 14. This is presumed to be because the base layer 12 had on the surface thereof polar groups (e.g., hydroxyl groups) formed by contact of the elemental metal or metal layer with the air and the polar groups have enhanced the interaction between the base layer 12 and the oil-containing layer 14.

In addition, since the base layer 12 is either an elemental metal or a multilayer structure including a metal layer 124, the film has improved properties including mechanical strength, which is required when the film is removed from the object of interest, heat resistance, and cold resistance.

<Method for producing the Film>

The film according to this embodiment may be produced through the steps of (a) applying a resin composition including a polymer ingredient and an oil ingredient to a surface of the base layer 12 and (b) curing the obtained coating film to form an oil-containing layer 14.

(Step (a))

In step (a), a resin composition including a polymer ingredient and an oil ingredient in any desired proportion is produced. The resin composition may contain other ingredients such as those shown above. The resin composition is preferably stirred until the rawmaterial ingredients become evenly mixed, and a stirrer may be used.

In cases when the resin composition contains air, the oil-containing layer formed therefrom is likely to contain air bubbles. Since this may result in a decrease in film strength or an impaired product appearance, it is preferred to conduct degassing. Examples of methods for the degassing include a method in which the resin composition is defoamed with a planetary stirrer for several seconds to about 5 minutes and a method in which the resin composition is depressurized in a vacuum for several seconds to about 30 minutes.

The resin composition thus obtained is applied to a surface of the base layer 12 to form a coating film (oil-containing layer 14) so that the elemental metal or the metal layer 124 comes into contact with the oil-containing layer 14. Methods for the application are not particularly limited, and examples thereof include a method in which the resin composition is applied by cast coating with an applicator and a method in which the resin composition is applied with a brush.

(Step (b))

In step (b), the coating film obtained in step (a) is cured to form an oil-containing layer 14. The curing can be conducted by a conventionally known method, and examples thereof include a method in which the coating film is dried by heating, a method in which the coating film is cured by ultraviolet irradiation, and a method in which a crosslinking agent is added.

In the case of the drying by heating, it is preferred to heat the coating film at 100-160°C for 1-300 minutes.

Thus, the film according to this embodiment is obtained.

A thickness of the film according to this embodiment can be suitably selected in the range of 0.06-3.5 mm, in view of the desired strength of the film, the size of an object of interest (structure) to which the film is applied, etc.

The film according to this embodiment may have a configuration, as another embodiment, which includes a pressure-sensitive adhesive layer, a base layer 12, and an oil-containing layer 14 in this order.

Fig. 3 is a cross-sectional view for explaining such another embodiment of the film of the present invention.

The film 104 shown as an embodiment in Fig. 3 includes a base layer 12 and an oil-containing layer 14 formed on the base layer 12. Furthermore, a pressure-sensitive adhesive layer 16 has been disposed on that surface of the base layer 12 which is on the reverse side from the oil-containing layer 14.

Examples of materials for the pressure-sensitive adhesive layer 16 include pressure-sensitive adhesives based on an acrylic resin, pressure-sensitive adhesives based on an epoxy resin, pressure-sensitive adhesives based on an amino resin, pressure-sensitive adhesives based on a vinyl resin (e.g., vinyl-acetate-based polymer), pressure-sensitive adhesives based on a curable acrylic resin, and pressure-sensitive adhesives based on a silicone resin. One material only may be used for constituting the pressure-sensitive adhesive layer 16, or two or more materials may be used therefor.

The pressure-sensitive adhesive layer 16 has a thickness of preferably 10-100 μm, more preferably 25-75 μm. The pressure-sensitive adhesive layer 16 can be formed, for example, by a known coating method.

Meanwhile, Fig. 4 is a cross-sectional view for explaining still another embodiment of the film of the present invention. The film 106 shown as an embodiment in Fig. 4 includes a base layer 12 and an oil-containing layer 14 formed on the base layer 12. Furthermore, a pressure-sensitive adhesive layer 16 has been disposed on that surface of the base layer 12 which is on the reverse side from the oil-containing layer 14. In the embodiment shown in Fig. 4, the base layer 12 includes a resin layer 122. Because of this, a metal layer 126 has been provided to that surface of the resin layer 122 which in on the reverse side from the oil-containing layer 14. Details of the metal layer 126 are the same as those of the metal layer 124 explained above, and preferred ranges therefor are also the same.

In the films 104 and 106 shown as embodiments in Figs. 3 and 4, the pressure-sensitive layers 16 are in contact with the base layer 12 constituted of an elemental metal or with the metal layer 126 provided to the resin layer 122 and hence have satisfactory adhesion to the base layers 12. This is presumed to be because the base layer 12 had on the surface thereof polar groups (e.g., hydroxyl groups) formed by contact of the elemental metal or metal layer with the air, as stated above, and the polar groups have enhanced the interaction between the base layer 12 and the pressure-sensitive adhesive layer 16. This improvement in adhesion can, for example, prevent each film according to the embodiment from leaving a residue of the pressure-sensitive adhesive layer 16 (adhesive residue) on the object of interest when removed from the object.

The films according to this embodiment are used in the state of having been disposed on surfaces of objects of interest (structures). Examples of the objects of interest include objects which are exposed to natural environments including snowfalls, rainfalls, winds, etc., such as, for example, airplanes, railway vehicles, motor vehicles, wind-power generators, dwelling houses, traffic signals, and signboards. Meanwhile, the films according to this embodiment are effective also against objects which are likely to suffer the adhesion of aquatic organisms thereto, and examples of such objects include underwater structures (ships, buoys, harbor equipment, offshore oil well equipment, cooling-water channels of electric power plants, cooling-water channels of factories, floating passages on water, etc.).

EXAMPLES

The present invention is explained below in more detail by reference to Examples and Comparative Examples, but the present invention is not limited to the following Examples. In the Examples and Comparative Examples, the term "parts" means parts by mass.

(Production Example 1: Production of Resin Composition)

Fifty parts of a silicone resin obtained by mixing KE-1950-50A and KE-1950-50B in a mass ratio of 1:1 (both manufactured by Shin-Etsu Chemical Co., Ltd.; two-pack type RTV rubber), 30 parts of KF-96-50cs (silicone oil manufactured by Shin-Etsu Chemical Co., Ltd.), and 20 parts of TSF-437 (silicone oil manufactured by Momentive Performance Materials Japan LLC) were evenly mixed by stirring to produce a resin composition.

(Example 1)

The resin composition produced in Production Example 1 was evenly applied to soft aluminum (aluminum foil; manufactured by Toyo Aluminum K.K.; trade name "1N30"; thickness, 80 μm) using an applicator so as to result in a dry oil-containing-layer thickness of 150 μm. Thereafter, the applied resin composition was dried at 150°C for 10 minutes to form an oil-containing layer. Thus, a film of Example 1 was produced.

(Example 2)

The same procedure as in Example 1 was repeated, except that the soft aluminum was replaced by a poly(ethylene terephthalate) (PET) coated with vapor-deposited aluminum (manufactured by Toray Advanced Film Co., Ltd.; trade name "Metalmy TS (#50)"; thickness, 50 μm) and that a film was configured so that the oil-containing layer was in contact with the vapor-deposited aluminum layer. Thus, a film of Example 2 was produced.

(Example 3)

The same procedure as in Example 1 was repeated, except that the soft aluminum was replaced by a copper foil (manufactured by The Furukawa Electric Co., Ltd.; trade name "C1020R"; thickness, 50 μm) and that a film was configured so that the oil-containing layer was in contact with the elemental metal. Thus, a film of Example 3 was produced.

(Example 4)

The same procedure as in Example 1 was repeated, except that the soft aluminum was replaced by hard aluminum (aluminum foil; manufactured by Toyo Aluminum K.K.; thickness, 50 μm) and that a film was configured so that the oil-containing layer was in contact with the elemental metal. Thus, a film of Example 4 was produced.

(Example 5)

The same procedure as in Example 1 was repeated, except that the soft aluminum was replaced by a stainless-steel foil (manufactured by AS ONE Corp.; No. "NI-100×300×0.1"; thickness, 100 μm) and that a film was configured so that the oil-containing layer was in contact with the elemental metal. Thus, a film of Example 5 was produced.

(Example 6)

The same procedure as in Example 1 was repeated, except that the soft aluminum was replaced by a nickel foil (manufactured by AS ONE Corp.; No. "SUS-□100×0.1"; thickness, 100 μm) and that a film was configured so that the oil-containing layer was in contact with the elemental metal. Thus, a film of Example 6 was produced.

(Comparative Example 1) to (Comparative Example 5)

The same procedure as in Example 1 was repeated, except that the soft aluminum was replaced by each of the base layers shown in Table 1, which will be given layer, and that the heat-curing temperature was changed to the temperatures shown in Table 1. Thus, various films of Comparative Examples 1 to 5 were produced.
The materials of the base layers in Comparative Examples 1 to 5 are as follows.

Ionomer: trade name HIMILAN (registered trademark) 1855, manufactured by Kurabo Industries Ltd.; polyethylene-based ionomer
Acrylic resin: trade name ACRYPLEN (registered trademark), manufactured by Mitsubishi Chemical Corp.; acrylic resin film
Polycarbonate: trade name Iupilon (registered trademark), manufactured by Mitsubishi Gas Chemical Company Inc.; polycarbonate
Urethane: trade name ESMER (registered trademark) URS PX, manufactured by Nihon Matai Co., Ltd.
PET: trade name Lumirror (registered trademark) S10, manufactured by Toray Industries, Inc.

The films of the Examples and Comparative Examples thus produced were subjected to the following test experiments.

Contact Angle:

The base layers were examined for contact angle using pure water, diiodomethane, and ethylene glycol as testing liquids having known surface tensions. In each of Examples 1 to 6, the elemental metal or the metal layer was examined for contact angle. In Comparative Examples 1 to 5, the resins were examined for contact angle. The contact angle with each testing liquid was determined by using the testing liquid in an amount of 2 μL to make a measurement with contact angle meter type DM-701 (manufactured by Kyowa Interface Science Co. Ltd.) with respect to each of five points, excluding maximum and minimum values from the five measured values, and calculating an average of the remaining three measured values.

Surface Free Energy (ys, ysd, ysp, ysh):

The surface free energy (ys) of each base layer and components thereof (dispersive component ysd, polar component ysp, and hydrogen-bonding component ysh) were determined from the contact angles obtained above, by the Kitazaki-Hata method (see KITAZAKI yasuaki et al., Journal of the Adhesion Society of Japan, Vol. 8, No. 3, 1972, pp. 131-141). In each of Examples 1 to 6, the elemental metal or the metal layer was thus examined for surface free energy. In Comparative Examples 1 to 5, the resins were examined for surface free energy.

Oil Bleed Amount:

An oil-containing layer having a size of 10 cm × 2 cm cut out of a nearly center portion of each film was allowed to stand at a temperature of -20°C for 16 hours, and the oil which had bled out during the standing to the surface of the oil-containing layer was collected with a cell scraper (trade name "CSS-10", manufactured by KENIS Ltd.) in the environment having a temperature of -20°C and then blotted up therefrom with an oil blotting paper until the weight of the blotting paper (oil absorption) became unchanged. The oil collection with a cell scraper and the blotting with an oil blotting paper were repeatedly conducted 7 times over 1 minute. The difference in the weight of the oil blotting paper between before and after each oil blotting was taken as oil bleed amount. This test was performed three times, and an average of the measured amounts was calculated.

Ice Adhesion Strength:

First, a cylindrical ice block was produced. The ice block was produced by placing a stainless-steel ring (inner diameter, 25 mm) on the bottom of rectangular styrol case Type 16 (manufactured by AS ONE Corp.), pouring 6 g of pure water thereinto, placing this case at -20°C for 16 hours or longer to freeze the water, and removing the stainless-steel ring after the freezing.

Subsequently, each film which had been allowed to stand in a -20°C environment for 16 hours was bonded to a stainless-steel plate placed parallel with the floor surface, so that the oil-containing layer faced upward. The cylindrical ice block was caused to adhere thereto so as to result in an adhesion area of 4.9 $cm^2$.

The temperature of the environment was set at -20°C, and at 3 hours after the adhesion of the cylindrical ice block, the ice block was pushed with a load cell (DPU-50, manufactured by Imada Co., Ltd.; attachment jig, Type A, A-4) from a direction parallel with the floor surface at a speed of 0.1 mm/sec in the environment of -20°C. The loads which were imposed over 40 seconds were measured with a force gauge (ZTS-50N, manufactured by Imada Co., Ltd.), and a value obtained by dividing a maximum measured load by the adhesion area of 4.9 $cm^2$ was recorded as an ice adhesion strength. This test was conducted three times and an average of the three values was determined.

Bleeding Temperature:

Bleeding temperature was examined using an optical microscope and a closed Peltier cooling/heating stage and determined from set temperatures of the Peltier element. Each film was bonded to the Peltier cooling/heating stage so that the oil-containing layer faced upward, and purging with nitrogen gas was conducted to make the environment dry.

The set temperature of the Peltier element was lowered from ordinary temperature (20°C) 2°C by 2°C to cool the oil-containing layer. After the temperature of the Peltier element had reached each set temperature, the stage was held for 5 minutes before the oil-containing layer was examined for bleeding. For the bleed examination, a lens having an optical magnification of 100 times was used.

Snow Slip Property:

Each produced film was cut into a size of 10 cm (length) × 10 cm (width) (area, 100 $cm^2$) and bonded to an

acrylic plate of 10 cm (length) × 10 cm (width) (area, 100 $cm^2$) so that the oil-containing layer faced upward. This specimen was disposed in a test chamber having a set environment temperature of 1°C.

A mass of wet snow was adhered in an amount of about 20 g to the surface of the film disposed horizontally. The acrylic plate having the snow mass adherent thereto was disposed obliquely to the floor surface at an angle of 60° therewith, and whether a fall of the snow mass occurred or not was visually examined over a time period of up to 1 hour after the oblique disposition. The case where a fall of the snow mass was observed is indicated by "o", and the case where a fall thereof was not observed is indicated by "×".

Adhesion:

Adhesion between the base layer and the oil-containing layer was evaluated by a crosscut method in accordance with JIS K 5600. The surface of the oil-containing layer was incised with a cutting knife or the like at intervals of 1 mm to make 25 squares in total in a grid arrangement. Cellotape (registered trademark) (trade name "610-1PK", manufactured by 3M Company) which had been cut into a length of about 75 mm was applied to the surface of the squares. Thereafter, an end of the tape was pinched to peel off the tape in the direction of 60 degrees over 0.5-1 second, and the state of the oil-containing layer was visually examined for separation. The case where the proportion of squares in which the oil-containing layer remained was 90% or higher was rated as good (o), and the case where the proportion thereof was less than 90% was rated as poor (×).

Anchoring Force:

An acrylic double-sided pressure-sensitive adhesive tape (trade name CS9862UA, manufactured by Nitto Denko Corp.) was applied to an aluminum plate. The separator of this double-sided pressure-sensitive adhesive tape was stripped off, and each film was bonded to the adhesive surface of the double-sided pressure-sensitive adhesive tape so that the oil-containing layer faced upward. This film was set on a tensile tester, and the base layer and the pressure-sensitive adhesive layer were peeled from each other in the direction of 180° at a speed of 300 mm/min. The peel force [N/25 mm] measured in this peeling was taken as anchoring force.

Oil Absorption of Base Layer:

The oil absorption of each base layer was determined in accordance with JIS K 7114:2001 (ISO 175:1999).

The base layer which had been cut into a given size was immersed at 23°C for 24 hours in an oil (dimethyl silicone oil; trade name "KF-96 50cs") contained in a vessel. Thereafter, the oil adherent to the surfaces was wiped off with a waste. The weight of the base layer was measured with a balance before and after the immersion.

The oil absorption of the base layer was determined using the following equation.

$$\text{Oil absorption} = W1 - W0$$

W0 means the weight of the base layer before the test and W1 means the weight of the base layer after the test.

The test was conducted under the conditions of an oil amount of 50 g and a film sample area of 6 $cm^2$.

The results of each test are shown in Table 1.

[Table 1]

Table 1

| | Material of base layer | Thickness of base layer (µm) | Contact angle (base layer) Water (°) | Diiodomethane (°) | Ethylene glycol (°) | Surface free energy (base layer) Dispersive component γsd (mJ/m$^2$) | Polar component γsp (mJ/m$^2$) | Hydrogen-bonding component γsh (mJ/m$^2$) | Surface free energy γs (mJ/m$^2$) |
|---|---|---|---|---|---|---|---|---|---|
| Example 1 | soft aluminum | 80 | 67 | 38 | 54 | 23.5 | 38.1 | 7.0 | 68.0 |
| Example 2 | PET coated with vapor-deposited aluminum | 50 | 78 | 34 | 63 | 27.3 | 28.7 | 2.1 | 58.1 |
| Example 3 | copper foil | 80 | 70 | 34 | 51 | 29.8 | 20.7 | 4.6 | 55.1 |
| Example 4 | hard aluminum | 50 | 68 | 30 | 51 | 28.0 | 31.0 | 5.4 | 64.0 |
| Example 5 | stainless-steel foil | 100 | 74 | 28 | 55 | 30.7 | 24.5 | 2.8 | 58.0 |
| Example 6 | nickel foil | 100 | 66 | 30 | 42 | 33.0 | 16.4 | 5.7 | 55.1 |
| Comparative Example 1 | ionomer | 100 | 75 | 38 | 45 | 41.8 | 6.0 | 1.6 | 49.0 |
| Comparative Example 2 | acrylic resin | 75 | 89 | 43 | 64 | 34.6 | 3.6 | 0.2 | 38.0 |
| Comparative Example 3 | polycarbonate | 125 | 90 | 41 | 65 | 35.6 | 3.5 | 0.2 | 39.0 |
| Comparative Example 4 | urethane | 100 | 92 | 50 | 71 | 28.9 | 6.4 | 0 | 36.0 |
| Comparative Example 5 | PET | 80 | 86 | 41 | 60 | 35.8 | 3.3 | 0.5 | 40.0 |

(to be continued)

Table 1 (continued)

| | Heat-curing temperature (°C) | Oil bleed amount (µg/cm$^2$) | Ice adhesion strength (N/cm$^2$) | Bleeding temperature (°C) | Snow slip property | Adhesion | Anchoring force (N/25 mm) | Oil absorption of base layer*1 (µg/cm$^2$) |
|---|---|---|---|---|---|---|---|---|
| Example 1 | 150 | 891 | 0.04 | −2 | ○ | ○ | 12.5 | 165 |
| Example 2 | 150 | 450 | 0.18 | −2 | ○ | ○ | 11.2 | 152 |
| Example 3 | 150 | 421 | 0.12 | −2 | ○ | ○ | 10.9 | 182 |
| Example 4 | 150 | 587 | 0.12 | −2 | ○ | ○ | 11.5 | 101 |
| Example 5 | 150 | 555 | 0.13 | −2 | ○ | ○ | 10.5 | 123 |
| Example 6 | 150 | 621 | 0.15 | −2 | ○ | ○ | 10.3 | 117 |
| Comparative Example 1 | 150 | 505 | 0.11 | −2 | ○ | ○ | 6.2 | 212 |
| Comparative Example 2 | 80 | 650 | 0.54 | −2 | ○ | × | 4.4 | 147 |
| Comparative Example 3 | 80 | 286 | 0.06 | −2 | ○ | × | 3.2 | 238 |
| Comparative Example 4 | 80 | 47 | 0.62 | ≤−16 | × | × | 6.5 | 300 |
| Comparative Example 5 | 150 | 328 | 0.19 | −2 | ○ | × | 5.1 | 290 |

*1: Oil absorption of 200 µg/cm$^2$ or less can be deemed to be sufficiently low.

It can be seen from the results given in Table 1 that since the films of the Examples each included an elemental metal or a metal layer disposed as a portion in contact with the oil-containing layer, the films of the Examples were prevented from suffering the reabsorption of the bled oil by the base, were excellent in terms of adhesion between the base layer and the oil-containing layer, and were capable of satisfactorily preventing the accretion of snow or ice or the adhesion of aquatic organisms to surfaces of objects of interest, as compared with the films of the Comparative Examples, which did not have configuration.

While preferred embodiments of the present invention have been explained above, the present invention is not limited to those embodiments and various modifications and replacements can be made in the embodiments without departing from the scope of the invention.

This application is based on a Japanese patent application filed on September 27, 2019 (Application No. 2019-177847), the contents thereof being incorporated herein by reference.

INDUSTRIAL APPLICABILITY

The film of the present invention is used in the state of having been disposed on surfaces of objects of interest (structures). Examples of the objects of interest include objects which are exposed to natural environments including snowfalls, rainfalls, winds, etc., such as, for example, airplanes, railway vehicles, motor vehicles, wind-power generators, dwelling houses, traffic signals, and signboards. The film thus has the function of preventing snow/ice accretion. Meanwhile, the film of the present invention is effective also against objects which are likely to suffer the adhesion of aquatic organisms thereto, and examples of such objects include underwater structures such as ships, buoys, harbor equipment, offshore oil well equipment, cooling-water channels of electric power plants, cooling-water channels of factories, floating

passages on water, etc. The film thus has the effect of preventing the adhesion of aquatic organisms.

## REFERENCE SIGNS LIST

| | |
|---|---|
| 100, 102, 104, 106 | Film |
| 12 | Base layer |
| 14 | Oil-containing layer |
| 16 | Pressure-sensitive adhesive layer |
| 122 | Resin layer |
| 124, 126 | Metal layer |

## Claims

1. A film comprising a base layer and an oil-containing layer formed on the base layer, wherein

   the oil-containing layer contains an oil ingredient which bleeds out from a surface of the oil-containing layer at a given temperature or lower,
   the base layer is an elemental metal or a multilayer structure including a metal layer, and
   the elemental metal or the metal layer is in contact with the oil-containing layer.

2. The film according to claim 1, wherein the base layer is aluminum.

3. The film according to claim 1, wherein the base layer is a multilayer structure comprising a resin layer and a metal layer formed thereon, the metal layer being a vapor-deposited metal layer.

4. The film according to claim 3, wherein the vapor-deposited metal layer comprises aluminum.

5. The film according to any one of claims 1 to 4, which comprises a pressure-sensitive adhesive layer, the base layer, and the oil-containing layer in this order.

6. The film according to claim 5, wherein the base layer includes an elemental metal or a multilayer structure including a metal layer, on the side where the pressure-sensitive adhesive layer is provided, and the elemental metal or the metal layer is in contact with the pressure-sensitive adhesive layer.

7. The film according to any one of claims 1 to 6, which is for use in preventing a surface of an object from suffering snow or ice accretion thereto or the adhesion of aquatic organisms thereto.

8. A method for producing the film according to any one of claims 1 to 7, which comprises a step in which a resin composition comprising a polymer ingredient and an oil ingredient is applied to a surface of the base layer and the obtained coating film is cured to form an oil-containing layer, wherein

   the oil ingredient contained in the oil-containing layer bleeds out from a surface of the oil-containing layer at a given temperature or lower,
   the base layer is an elemental metal or a multilayer structure including a metal layer, and
   the oil-containing layer is formed on the base layer so that the elemental metal or the metal layer is in contact with the oil-containing layer.

FIG. 1

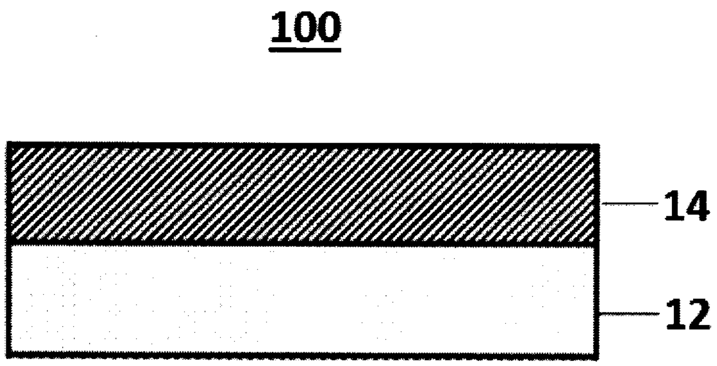

FIG. 2

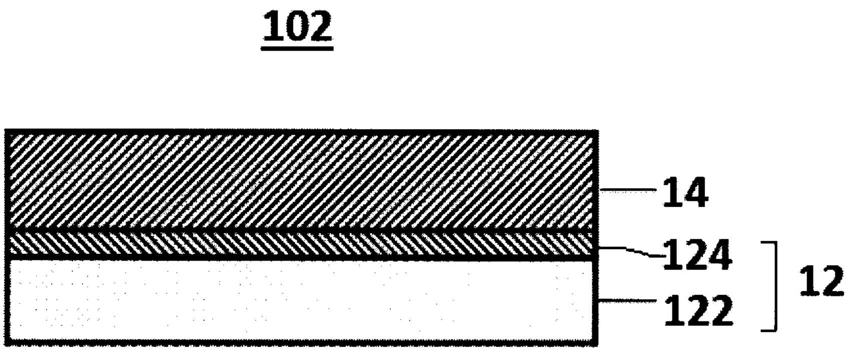

FIG. 3

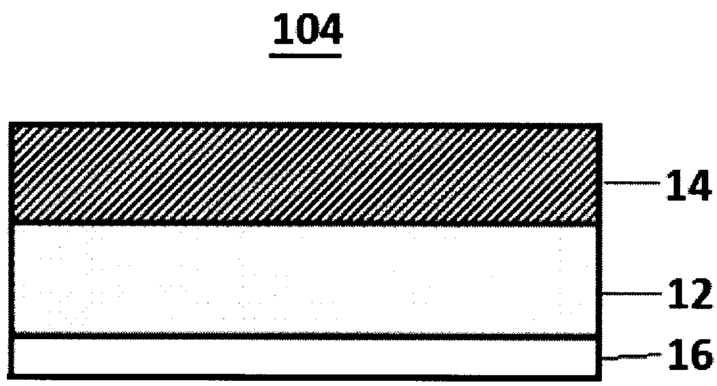

FIG. 4

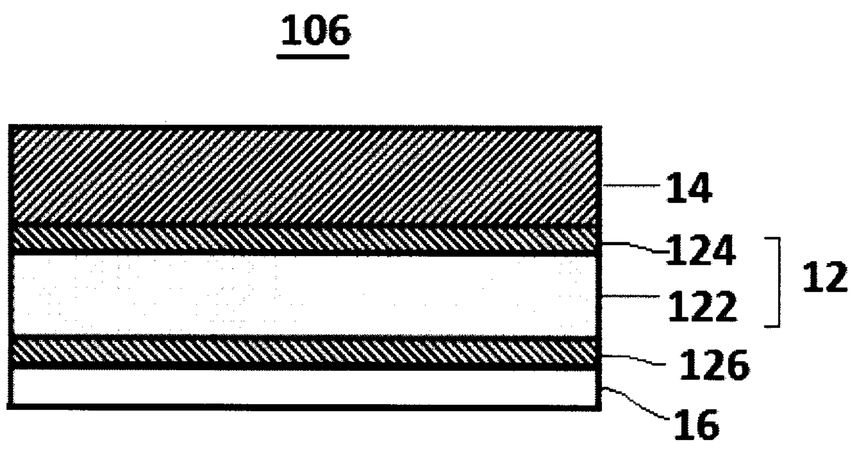

**INTERNATIONAL SEARCH REPORT**

International application No. PCT/JP2020/035853

A. CLASSIFICATION OF SUBJECT MATTER
C09K 3/18(2006.01)i; B32B 15/08(2006.01)i; C23C 26/00(2006.01)i
FI: B32B15/08 A; C23C26/00 A; C09K3/18 104

According to International Patent Classification (IPC) or to both national classification and IPC

B. FIELDS SEARCHED

Minimum documentation searched (classification system followed by classification symbols)
C09K3/18; B32B15/08; C23C26/00

Documentation searched other than minimum documentation to the extent that such documents are included in the fields searched

| | |
|---|---|
| Published examined utility model applications of Japan | 1922-1996 |
| Published unexamined utility model applications of Japan | 1971-2020 |
| Registered utility model specifications of Japan | 1996-2020 |
| Published registered utility model applications of Japan | 1994-2020 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2011-94085 A (HIRAOKA & CO., LTD.) 12 May 2011 (2011-05-12) claims 1-3, paragraphs [0011], [0014], [0020]-[0022], examples 5, 6, fig. 1-4 | 1, 2 |
| A | entire text, all drawings | 3-8 |
| A | JP 2001-181509 A (CHUGOKU MARINE PAINTS, LTD.) 03 July 2001 (2001-07-03) entire text | 1-8 |
| A | JP 7-148879 A (SHIN-ETSU CHEMICAL CO., LTD.) 13 June 1995 (1995-06-13) entire text | 1-8 |

☐ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 26 October 2020 (26.10.2020) | 10 November 2020 (10.11.2020) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**
Information on patent family members

International application No.
PCT/JP2020/035853

| Patent Documents referred in the Report | Publication Date | Patent Family | Publication Date |
|---|---|---|---|
| JP 2011-94085 A | 12 May 2011 | (Family: none) | |
| JP 2001-181509 A | 03 Jul. 2010 | US 2002/0197490 A1<br>entire text<br>EP 1092758 A2 | |
| JP 7-148879 A | 13 Jun. 1995 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 62252477 A
- JP 2019177847 A


### Non-patent literature cited in the description


- **KITAZAKI YASUAKI et al.** *Journal of the Adhesion Society of Japan,* 1972, vol. 8 (3), 131-141